# EUROPÄISCHE PATENTSCHRIFT

(11) **EP 2 006 986 B1**
(45) Veröffentlichungstag und Bekanntmachung des Hinweises auf die Patenterteilung: **28.08.2013**
(21) Anmeldenummer: 07011248.7
(22) Anmeldetag: 08.06.2007
(51) Int. Cl.: H05K 5/00

(54) **Wechselrichter, umfassend ein Gehäuse**
Inverter, including a casing
Onduleur comprenant un boîtier

(43) Veröffentlichungstag der Anmeldung: 24.12.2008
(73) Patentinhaber: SMA Solar Technology AG, 34266 Niestetal (DE)
(72) Erfinder: Bremicker, Sven, 36211 Alheim (DE); Donth, Andreas, 34295 Edermünde (DE); Andrae, Ralf, 34379 Calden (DE); Häde, Johannes, 36211 Alheim (DE); Yasar, Nafiz, 33098 Paderborn (DE); Victor, Matthias Dr., 34266 Niestetal (DE)
(74) Vertreter: Walther, Walther & Hinz GbR

(56) Entgegenhaltungen:
- EP-A- 0 854 565
- EP-A- 1 303 173
- FR-A- 2 823 058
- US-B1- 6 445 585
- US-B1- 6 778 381

## Beschreibung

Die vorliegende Erfindung betrifft einen Wechselrichter, umfassend ein Gehäuse.

Aus der FR 2823058 ist ein Gleichrichter mit einem Gehäuse bekannt, der eine Tastatur auf einem Beschriftungsfeld zeigt. Darüber hinaus sind außen an dem Gehäuse des Gleichrichters Steckverbinder vorgesehen.

Die EP 0 854 565 A2 zeigt ein Gehäuse eines Wechselrichters, wobei die leistungselektronischen Bauteile in einer Kammer des Gehäuses untergebracht sind. Anschließend an diese Kammer ist im Gehäuse eine zweite Kammer vorgesehen, die ein Gebläse aufweist, das in der zweiten Kammer angeordnete Kühlrippen kühlt. Hierbei besteht zwischen den beiden Kammern ein Durchlass, um Kühlluft auch in die Kammer mit den leistungselektronischen Bauteilen zu transportieren.

die US 6,778,381 B1 zeigt ein Gehäuse mit Rechnereinschüben, wobei die Rechnereinschübe einzeln herausgezogen werden können und sich im herausgezogenen Zustand ein Display herabklappen lässt.

Wechselrichter dienen bei der Nutzung alternativer Energiequellen, wie z. B. PV-Modulen dazu, Gleichstrom in Wechselstrom umzuwandeln. Ein solcher Wechselrichter weist ein Gehäuse auf, wobei in dem Gehäuse leistungselektronische Bauteile angeordnet sind. Diese leistungselektronischen Bauteile sind vor Umwelteinflüssen, insbesondere vor Feuchtigkeit, zu schützen. Ein solcher Wechselrichter umfasst nicht nur leistungselektronische Bauteile, sondern darüber hinaus insbesondere eine Vielzahl von Steckern, um diesen Wechselrichter AC- und DC-seitig anzuschließen. Darüber hinaus besitzt ein solcher Wechselrichter auch eine Kommunikationseinheit mit einem Display, das ebenfalls angeschlossen werden muss. Ein solches Display ist im Wechselrichter von außen durch eine entsprechende Öffnung im Deckel sichtbar. Darüber hinaus sind optional nachrüstbare Kommunikationsschnittstellen vorgesehen, die durch Kabeldurchführungen in der Wand zu der anderen Kammer anschließbar sind.

Wie bereits an anderer Stelle erläutert, nimmt ein solches Gehäuse eines Wechselrichters sowohl leistungselektronische Bauteile auf als auch andere elektrische Bauteile, wie z. B. Stecker oder eben auch eine Kommunikationseinheit mit einem Display auf. Die leistungselektronischen Bauteile sind einer höheren Schutzartklasse unterworfen als die übrigen elektrischen Bauteile. Insofern können diese Bauteile in einer gesonderten Kammer untergebracht sein, die eine spezielle Schutzartklasse aufweist, nämlich insbesondere die Schutzartklasse IP65. Das bedeutet, dass in der anderen Kammer die übrigen Bauteile angeordnet sind. Insbesondere sind eine Vielzahl von Steckverbindungen vorgesehen, da der Wechselrichter sowohl AC- als auch DC-seitig mit dem PV-Modul bzw. mit dem Netz verbunden werden muss. Die Anordnung der Stecker erfolgt üblicherweise im Bereich der Wand zwischen den beiden Kammern. Wie bereits ebenfalls ausgeführt, befindet sich das Display der Kommunikationseinheit in der einen Kammer, die üblicherweise nicht die leistungselektronischen Bauteile aufnimmt. Ein solches Display mit einer Kommunikationseinheit hat eine bestimmte Größe, die bereits einen nicht unerheblichen Platzbedarf in der Kammer einnimmt, die insbesondere die Steckverbinder für den AC und den DC-Anschluss aufnimmt.

Die der Erfindung zu Grunde liegende Aufgabe besteht nun darin, den Platzbedarf durch die Kommunikationseinheit mit dem Display nicht durch ein entsprechend größeres Gehäuse für den Wechselrichter kompensieren zu müssen.

Zur Lösung der Aufgabe wird erfindungsgemäß vorgeschlagen, dass das Display verschwenkbar in der Kammer angeordnet ist, wobei sich unter dem Display Bauteile befinden, die nach Verschwenken des Displays zugänglich sind. Das bedeutet, dass bei abgenommenem Deckel das Display nach außen, d. h. in Richtung auf den abgenommenen Deckel zu verschwenkbar ist. In der ausgeschwenkten Position ist der Raum unter der Kommunikationseinheit mit dem Display unmittelbar zugänglich. Insbesondere dann, wenn der Abstand der Kommunikationseinheit mit dem Display zum Boden des Gehäuses bzw. zum Boden der Kammer, die die Kommunikationseinheit mit dem Display aufnimmt, eine bestimmte Höhe nicht unterschreitet, besteht insofern die Möglichkeit, unter dem Display noch Steckverbindungen oder andere Bauteile, insbesondere Kommunikationsschnittstellen, unterzubringen, die durch Verschwenken des Displays dann tatsächlich zugänglich werden. Das heißt, der Raum unter dem Display ist im Prinzip ohne Demontage des Displays zugänglich. Ein solcher Schwenkmechanismus für das Display der Kommunikationseinheit bzw. für die Kommunikationseinheit als solche ermöglicht die volle Ausnutzung des Platzangebotes im Gehäuse eines Wechselrichters insbesondere im Wandbereich des Übergangs zwischen zwei Gehäusekammern, um dort unterhalb der Kommunikationseinheit mit dem Display gegebenenfalls weitere elektrische Bauelemente, und hier insbesondere Stecker, zur AC- bzw. DC-seitigen Verbindung des Wechselrichters mit den leistungselektronischen Baugruppen, unterzubringen. Insbesondere die Anordnung der Kommunikationseinheit in der Kammer des Gehäuses, das nicht die leistungselektronischen Bauteile aufnimmt, ermöglicht vom Grundsatz her einen risikofreien Zugang zu der Kammer zum Zwecke der Montage.

Vorteilhafte Merkmale der Erfindung ergeben sich aus den Unteransprüchen.

So ist insbesondere vorgesehen, dass die mindestens zwei Kammern des Gehäuses des Wechselrichters durch mindestens zwei voneinander getrennte Deckel abdeckbar sind. Hieraus wird noch einmal deutlich, dass unabhängig von dem Zugang zur Leistungselektronik, die sich in einer Kammer des mindestens aus zwei Kammern bestehenden Wechselrichtergehäuses befindet und von einem gesonderten Deckel abgedeckt wird, die Möglichkeit des relativ gefahrlosen Zugang zum Zweck der Montage oder Demontage der elektrischen Bauteile, der Stecker oder auch der Kommunikationseinheit besteht.

Zur Verschwenkbarkeit des Displays weist die Kammer insbesondere Mittel zur verschwenkbaren Aufnahme des Displays bzw. der Kommunikationseinheit auf. Im Einzelnen ist in diesem Zusammenhang vorgesehen, dass das Mittel mindestens ein Zapfen ist, der in eine entsprechende Aussparung des Displays bzw. der Kommunikationseinheit eingreift. Denkbar ist natürlich auch, dass der Zapfen am Display angeordnet ist und die Zapfenaufnahme an der Kammer. Das heißt, die Verbindung zwischen der Kommunikationseinheit und der Kammer ist ähnlich der eines Scharniers.

Wenn sich das Display einer Kommunikationseinheit nicht von dem einen Ende der Kammer bis zu dem anderen Ende der Kammer erstreckt, besteht die Möglichkeit, den einen Zapfen an der Wandung der Kammer anzuordnen und den anderen Zapfen gegenüberliegend auf einer Stütze, die auf dem Boden der Kammer des Gehäuses angeordnet ist.

Nach einem weiteren Merkmal der Erfindung ist vorgesehen, dass das Display im ausgeschwenkten Zustand fixierbar ist. Die Gehäuse von Wechselrichtern werden häufig im senkrechten Zustand montiert. Wird das Display nunmehr hochgeklappt, so besteht die Gefahr, dass bei einer Wandmontage des Wechselrichters das Display der Kommunikationseinheit wieder abklappt. Dies ist naturgemäß nicht gewünscht, wenn im Raum unterhalb des Displays Montagetätigkeiten durchgeführt werden sollen.

Insofern ist erfindungsgemäß vorgesehen, dass das Display im ausgeschwenkten Zustand fixierbar ist. An der Wand der Kammer und/oder an der Stütze ist eine Klemmeinrichtung vorgesehen, die einen weiteren an dem Display angeordneten Zapfen klemmend erfasst. Die Klemmeinrichtung umfasst im Einzelnen einen biegsamen Arm mit endseitig angeordnetem Vorsprung zum Erfassen des Zapfens oder der weiteren Zapfen.

Anhand der Zeichnungen wird die Erfindung nachstehende beispielhaft näher erläutert.

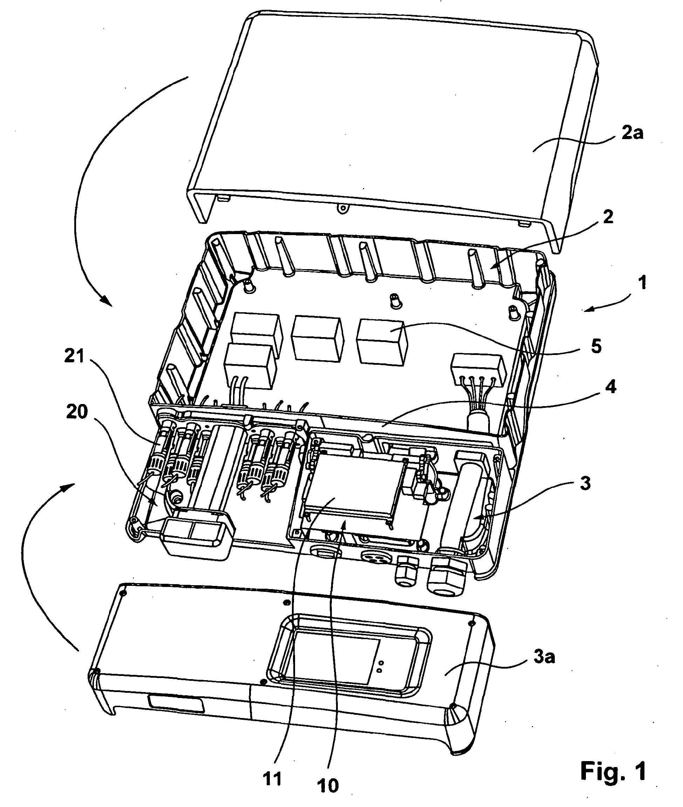

- Figur 1: zeigt das Gehäuse eines Wechselrichters mit einer Kommunikationseinheit mit einem Display im nicht ausgeschwenktem Zustand;
- Figur 2: zeigt einen Querschnitt aus der Darstellung gemäß Figur 1 mit ausgeschwenktem Display;
- Figur 3: zeigt eine Darstellung gemäß Figur 2, wobei in der einen Gehäusekammer lediglich der Schwenkmechanismus für das Display erkennbar ist;

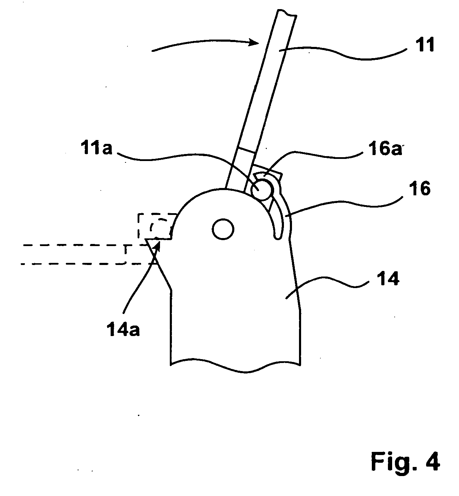

- Figur 4: zeigt die Klemmeinrichtung für das Display.

Das Gehäuse 1 des Wechselrichters umfasst die beiden Kammern 2 und 3, die durch eine Wand 4 voneinander getrennt sind; beide Kammern 2, 3 sind durch getrennte Deckel 2a, 3a verschließbar. Die Kammer 2 weist die leistungselektronischen Bauteile 5 auf, die allerdings nur schematisch angedeutet sind. In der Kammer 3 hingegen befindet sich die Kommunikationseinheit 10 mit dem Display 11. Neben der Kammer 3 ist ein Gehäuseabschnitt 20 vorgesehen, der der Aufnahme von Steckelementen 21 zur DC-seitigen Verbindung mit den PV-Modulen dient.

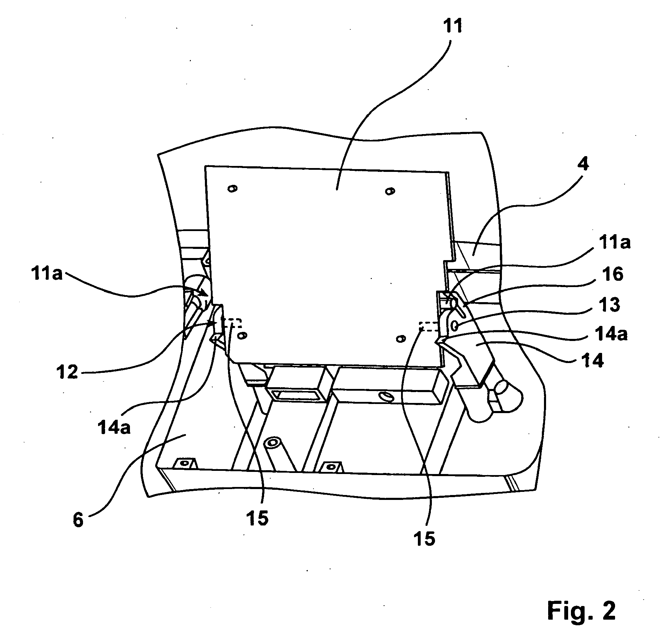

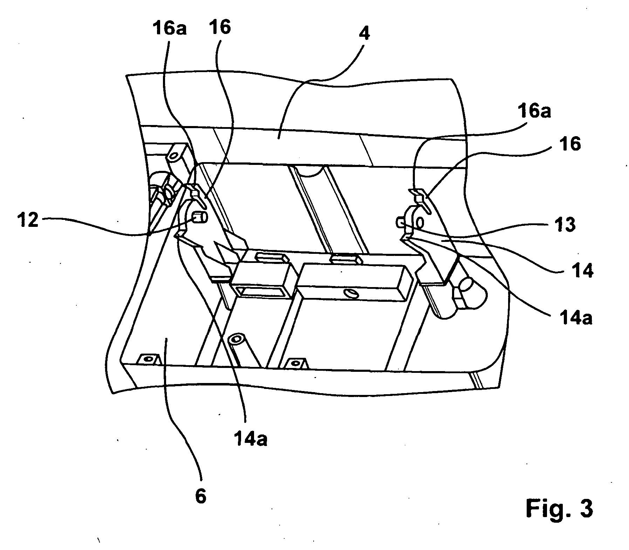

Gegenstand der Erfindung ist nun die Anordnung der Kommunikationseinheit 10 mit dem Display 11 in der Gehäusekammer 3. Betrachtet man in diesem Zusammenhang die Figur 2, so erkennt man die ausgeschwenkte Stellung des Displays 11. Zur verschwenkbaren Aufnahme des Displays 11, wie sich dies insbesondere aus Figur 2 und Figur 3 ergibt, ist zu beiden Seiten des Displays bzw. der Kommunikationseinheit jeweils ein Zapfen 12, 13 vorgesehen, wobei der Zapfen 12 an der Wand 6 der Gehäusekammer 3 angeordnet ist, wohingegen zur Aufnahme des Zapfens 13 eine Stütze 14 vorgesehen ist. Das Display selbst weist zur Aufnahme der Zapfen 12, 13 jeweils eine entsprechende Ausnehmung 15 auf, so dass die Aufnahme des Displays bzw. der Kommunikationseinheit durch die Zapfen 12, 13 im Sinne eines Scharniers erfolgt.

Das Display weist zu beiden Seiten jeweils einen weiteren Zapfen 11 a auf; sowohl an der Wandung 6 als auch an der Stütze 14 ist jeweils ein biegsamer Arm 16 vorgesehen, der endseitig einen Vorsprung 16a aufweist, um im aufgeklappten Zustand des Displays den jeweils weiteren Zapfen 11a klemmend aufzunehmen. Im abgeklappten Zustand des Displays lagert der weitere Zapfen auf einem tischartigen Vorsprung 14a, 12a. Unterhalb des Displays befinden sich Stecker oder andere Bauteile, die im aufgeklappten Zustand des Displays zugänglich sind.

## Patentansprüche

1. Wechselrichter, umfassend ein Gehäuse (1) mit mindestens zwei Kammern (2, 3), wobei in einer Kammer (2) die leistungselektronischen Bauteile (5) des Wechselrichters angeordnet sind, wobei in der anderen Kammer (3) das Display (11) einer Kommunikationseinheit (10) und andere elektrische Bauteile mit einer niedrigeren Schutzartklasse angeordnet sind, wobei das Display (11) verschwenkbar in der Kammer (3) angeordnet ist, wobei diese anderen Bauteile, die sich unter dem Display (11) befinden nach Verschwenken des Displays (11) zugänglich sind.

2. Wechselrichter nach Anspruch 1,
**dadurch gekennzeichnet,**
**dass** die Kammer (3) Mittel zur schwenkbaren Aufnahme des Displays (11) aufweist.

3. Wechselrichter nach Anspruch 2,
**dadurch gekennzeichnet,**
**dass** das Mittel mindestens ein Zapfen (12, 13) ist, der in einer entsprechenden Aussparung (15) des Displays (11) eingreift.

4. Wechselrichter nach Anspruch 3,
**dadurch gekennzeichnet,**
**dass** der eine Zapfen (13) an einer Stütze (14) angeordnet ist, die auf dem Boden der Kammer (3) angeordnet ist, und dass sich der zweite Zapfen (12) an der Wandung (6) der Kammer (3) befindet.

5. Wechselrichter nach einem der voranstehenden Ansprüche,
**dadurch gekennzeichnet,**
**dass** das Display (11) im ausgeschwenkten Zustand fixierbar ist.

6. Wechselrichter nach einem der Ansprüche 3 bis 5,
**dadurch gekennzeichnet,**
**dass** im Bereich des Zapfens (12, 13) an der Wand (6) der Kammer (3) und/oder der Stütze (14) eine Klemmeinrichtung (16, 16a) vorgesehen ist, die einen weiteren an dem Display angeordneten Zapfen (11a) klemmend im aufgeklappten Zustand des Displays (11) erfasst.

7. Wechselrichter nach einem der voranstehenden Ansprüche,
**dadurch gekennzeichnet,**
**dass** das Display (11) beabstandet zum Boden der Kammer (3) in der Kammer (3) verschwenkbar angeordnet ist.

8. Wechselrichter nach einem der voranstehenden Ansprüche,
**dadurch gekennzeichnet,**
**dass** die mindestens zwei Kammern (2, 3) des Gehäuses (1) des Wechselrichters durch mindestens zwei Deckel (2a, 3a) abdeckbar sind.

## Claims

1. Inverter, comprising a housing (1) having at least two chambers (2, 3), wherein the power electronics components (5) of the inverter are arranged in one chamber (2), wherein the display (11) of a communications unit (10) and other electrical components with a lower protection class are arranged in the other chamber (3), wherein the display (11) is arranged in a pivotable manner in the chamber (3), wherein these other components, which are located beneath the display (11), are accessible after pivoting the display (11).

2. Inverter according to Claim 1, **characterized in that** the chamber (3) comprises means for pivotably receiving the display (11).

3. Inverter according to Claim 2, **characterized in that** the means is at least one pin (12, 13) which engages in a corresponding cutout (15) in the display (11).

4. Inverter according to Claim 3, **characterized in that** the one pin (13) is arranged on a support (14) which is arranged on the floor of the chamber (3), and **in that** a second pin (12) is located on the wall (6) of the chamber (3).

5. Inverter according to one of the preceding claims, **characterized in that** the display (11) can be fixed in a pivoted-out state.

6. Inverter according to one of Claims 3 to 5, **characterized in that** a clamping device (16, 16a) is provided in the region of the one pin (12, 13) on the wall (6) of the chamber (3) and/or of the support (14), said clamping device grasping a further pin (11a), which is arranged on the display, in a clamping manner in the pivoted-out state of the display (11).

7. Inverter according to one of the preceding claims, **characterized in that** the display (11) is arranged in a pivotable manner in the chamber (3) at a distance from the floor of the chamber (3).

8. Inverter according to one of the preceding claims, **characterized in that** the at least two chambers (2, 3) of the housing (1) of the inverter can be covered by at least two covers (2a, 3a).

## Revendications

1. Onduleur comprenant un boîtier (1) avec au moins deux chambres (2, 3), les composants électroniques de puissance (5) de l'onduleur étant disposés dans une chambre (2), l'affichage (11) d'une unité de communication (10) et d'autres composants électriques de classe de protection plus basse étant disposés dans l'autre chambre (3), l'affichage (11) étant disposé de manière pivotante dans la chambre (3), ces autres composants, qui se trouvent sous l'affichage (11), étant accessibles après le pivotement de l'affichage (11).

2. Onduleur selon la revendication 1,
**caractérisé en ce que**
la chambre (3) présente un moyen pour la réception de manière pivotante de l'affichage (11).

3. Onduleur selon la revendication 2,
**caractérisé en ce que**
le moyen est au moins un tourillon (12, 13) qui vient en prise dans un évidement correspondant (15) de l'affichage (11).

4. Onduleur selon la revendication 3,
**caractérisé en ce que**
ledit le tourillon (13) est disposé sur un appui (14) qui est disposé sur le fond de la chambre (3), et **en ce que** un deuxième tourillon (12) se trouve sur la paroi (6) de la chambre (3).

5. Onduleur selon l'une quelconque des revendications précédentes,
**caractérisé en ce que**
l'affichage (11) peut être fixé dans l'état sorti par pivotement.

6. Onduleur selon l'une quelconque des revendications 3 à 5,
**caractérisé en ce que**
dans la région du tourillon (12, 13) au niveau de la paroi (6) de la chambre (3) et/ou de l'appui (14) est prévu un dispositif de serrage (16, 16a), lequel saisit par serrage un tourillon supplémentaire (11a) disposé sur l'affichage dans l'état redressé de l'affichage (11).

7. Onduleur selon l'une quelconque des revendications précédentes,
**caractérisé en ce que**
l'affichage (11) est disposé à distance du fond de la chambre (3) de manière à pouvoir pivoter dans la chambre (3).

8. Onduleur selon l'une quelconque des revendications précédentes,
**caractérisé en ce que**
les au moins deux chambres (2, 3) du boîtier (1) de l'onduleur peuvent être recouvertes par au moins deux couvercles (2a, 3a).
